# EUROPEAN PATENT SPECIFICATION

(11) **EP 2 650 614 B1**
(45) Date of publication and mention of the grant of the patent: **11.07.2018**
(21) Application number: 13175448.3
(22) Date of filing: 28.05.2010
(51) Int. Cl.: F24C 7/08, H05K 5/00, A47J 37/12

(54) **User interface and appliance of household or industrial type, especially domestic appliance**
Anwenderoberfläche und Haushaltsgerät oder Industriegerät, insbesondere Haushaltsgerät
Interface d'utilisateur et appareil de type domestique ou industriel, spécialement un appareil domestique

(43) Date of publication of application: 16.10.2013
(62) Divisional of application: 10005608.4
(73) Proprietor: Electrolux Home Products Corporation N.V., 1130 Brussels (BE)
(72) Inventor: Bunzel, Volkmar, 91541 Rothenburg/Tauber (DE); Feser, Jürgen, 91541 Rothenburg ob der Tauber (DE); Winkelmann, Klaus, 91541 Rothenburg ob der Tauber (DE); Taubner, Franz, 90763 Fürth (DE)
(74) Representative: Electrolux Group Patents

(56) References cited:
- EP-A1- 1 903 284
- EP-A1- 1 985 930
- EP-A2- 1 740 033
- EP-A2- 2 063 533
- DE-A1-102004 052 571
- DE-A1-102008 041 516
- GB-A- 2 022 872
- GB-A- 2 064 879

## Description

The present application is directed to a user interface and an appliance of household or industrial type, especially a domestic appliance, according to the preamble of claim 1.

A user interface for a cooking hob is known from DE 100 15 973 A1, for example. The user interface comprises an electronic board that is snap-connected to a mounting frame which is glued to a lower side of the cooking hob. The electronic board is mounted to the mounting frame via a push-and-rotate movement in that it is first inserted into an anchor section engaging an outer rim section thereof, and then it is rotated such that snap hooks engage an opposite rim section.

DE 199 50 829 A1 discloses a user interface for a baking oven. The user interface comprises a fixture to which an electronic interface unit is secured by means of a clamping frame which frame is snap-connected to the fixture.

DE 10 2008 041 516 A1 discloses a user interface for a household appliance in which touch-sensitive elements in form of conductive rubber elements are attached to an electronic board and are pressed against the rear side of stainless steel sections of a cover plate. Further variants of control panel arrangements for household appliances are known for example from EP 2 063 533 A2, GB 2 022 872 A, and EP 1 985 930 A1.

Document GB 2 064 879 A discloses a display and/or control unit adapted for marine use, where a display and touch unit are accommodated in a water-tight housing.

EP 1 740 033 A2 discloses a user interface with a casing. An insulating and transparent cover is attached at said casing. An electronic board is arranged inside the casing. Contact elements form an electric connection between the electronic board and the cover, when the casing is mounted to the cover.

EP 1 903 284 A1 discloses a user interface. A transparent cover is attached at a frame. A touch sensitive control sheet and an electronic board are arranged at the frame. The contact between the touch sensitive control sheet and the electronic board is obtained by contact elements, when the touch sensitive control sheet and the electronic board are mounted to the frame. Document EP 1 985 930 A1 relates to a control panel for a domestic appliance with switching element for influencing parameters of the appliance by touching its front side, wherein the switching element has at least one illumination element consisting of at least one lamp and at least one reflector element for indirectly lightning of a reverse side of the switching element.

Document DE 10 2004 052571 A1 relates to a control and indicator unit, e.g. for eguipment, having illuminators fitted onto the inside of a diffusing panel and with a reflector to concentrate the light onto the diffusing panel. A transparent panel is fitted to the outside of the diffusing panel and is provided with printed or applied symbols, e.g. symbols and alpha numeric characters. The transparent panel can be glass or plastic. The reflector has a curved upper section and a plane lower section.

It is an object of the invention to provide an alternative user interface for an appliance of household or industrial type. In particular, a user interface shall be provided which can be easily assembled and disassembled and which allows to reliably and precisely position and fix components thereof. Further, an appliance of household or industrial type shall be provided.
This object is achieved by independent claims 1 and 12. Embodiments of the invention result from dependent claims.

According to the present invention the user interface comprises at least one reflector unit arranged to a side of the touch-field control unit averted from the fixture or transparent cover, wherein the reflector unit presses the touch-field control unit against the fixture or transparent cover.
The touch-field control unit may comprise one or more individual touch-field elements or sensors. The user interface may comprise further active and passive actuators or control elements such as push and/or rotating type buttons, sliders and the like. A touch-field control unit in the sense of the present invention in particular shall allow a user to at least partially control the operation of a respective appliance, i. e. it shall allow active user intervention.
The user interface further comprises at least one electronic board. The electronic board may comprise electronic components for operating and controlling the touch-field control unit, and, if adequate, the appliance or at least some functions thereof.

The at least one touch-field control unit, and electronic board, - at least a respective pair of such elements - are detachably mounted to a mounting frame of the user interface. Further they are arranged and designed such that electronic contact between mutual electric contact elements thereof is automatically established upon mounting the respective touch-field control unit, and electronic board to the mounting frame. Obviously, automatically establishing electrical contact greatly simplifies the mounting process. In addition, faulty electric contacting can largely be prevented.

The user interface further comprises a fixture, which may be a front fixture to be positioned at or attached to a front panel of the appliance. A transparent cover, preferably made of glass, a glass analogue material or plastic, is positioned on the fixture and fixed, if required. Further, the mounting frame is attached to the fixture, in a more preferred embodiment attached to the transparent cover. The transparent cover may be part of a front or top face or cover plate presented and accessible to the user of the appliance. Transparency of the transparent cover in particular shall include all kinds of transparency and translucence.

The mounting frame is favourably attached to the fixture or transparent cover via glue or other suitable attachment means allowing safe and tight attachment. Here again, the mounting process is comparatively simple, straight forward and time saving.

In a further embodiment of the user interface, at least one pair of touch-field control unit and electronic board is arranged with at least partial overlap in successive planes. The contact elements are arranged in a region of overlap on respective sides of the touch-field control unit and electronic board facing each other. This configuration allows the respective touch-field control unit and electronic board to be successively attached to the mounting frame whilst guaranteeing automatic electric contacting.

Attachment of the touch-field control unit and electronic board to the mounting frame and electric contacting can be achieved with respective single attachment movements or steps, not requiring separate and additional steps for establishing electrical contacts. Note that the term in successive planes shall in particular mean that the respective planes are parallel and arranged one behind the other relative to the fixture or transparent cover.

In yet a further embodiment, the electronic board is detachably mounted to a positioning frame. The positioning frame in turn is detachably mounted to the mounting frame or fixture. Guiding elements or rails and respective engagement elements can be provided, specially adapted to secure safe, easy and proper alignment of the positioning frame relative to the touch-field control unit, mounting frame and fixture, respectively. Note that guiding elements or rails and respective engagement elements also can be provided in connection with the touch-field control unit or other components of the user interface in order to secure proper and easy alignment thereof.

As indicated beforehand, the user interface may comprise further components, in particular electronic components. Hence, in yet another embodiment, the user interface comprises at least one actuator detachably mounted to at least one of the mounting frame and positioning frame. The actuator may be a switch, control knob, in particular a rotary and/or push type knob or button. Preferably, at least one of an electric or mechanic contact to actuating elements, such as switches or push buttons and the like, is automatically established upon mounting the actuator to the mounting frame. Such a configuration simplifies attachment of additional actuators and the like and contributes to rapid and safe assembly of the user interface.

A further embodiment may comprise at least one reflector unit arranged downstream the touch-field control unit. Downstream in particular shall apply to a side of the touch-field control unit averted from the fixture or transparent cover. In the regular mounting position of the user interface the side averted from the fixture or transparent cover can be named rear or back side, whereas the side of the transparent cover can be named front side which generally is presented to and faces towards a user of the appliance.

The reflector unit is preferably designed and adapted such that it presses or urges the touch-field control unit, against or towards the fixture or transparent cover. Further, it is preferred that the positioning frame is adapted and designed such that it presses at least one of the touch-field control unit, against the fixture or transparent cover and the reflector unit against the touch-field control unit. Such a configuration expediently urges the touch-field control unit against rear sides of the fixture or transparent cover, and the reflector against the touch-field control unit. In this way, at least the touch-field control unit, and the reflector can be tightly and firmly attached and fixed in respective desired positions, leading to enhanced operability and functionality.

In an expedient embodiment, at least one of the mounting frame, positioning frame and fixture comprises at least one of snap elements and guides, in particular guide rails, designed and adapted to engage the at least one touch-field control unit, at least one electronic board, at least one actuator, at least one reflector and positioning frame, respectively. Such snap elements and guides preferably are adapted and designed for generating a pressing force towards the fixture or transparent cover, i.e. the components mentioned beforehand are pressed against or in a direction towards the fixture or transparent cover. Snap elements and guides provide easy and time saving assembly of the user interface. Also, the user interface can easily be disassembled for maintenance purposes for example, in particular in the case that one of the components has to be replaced.

It is of further advantage that at least one of the mounting frame, positioning frame and fixture comprises at least one of lateral stops, transversal stops and height or depth stops, arranged and adapted for proper alignment of the at least one touch-field unit, electronic board, actuator, reflector, the positioning frame and mounting frame, in particular relative to each other.

Using such stop elements, respective components of the user interface can be exactly oriented and positioned in at least two dimensions at respective levels, or even in three dimensions, relative to each other. This is of particular advantage because with the proposed user interface an electric contact between contact elements of the touch-field control unit and electronic board can be automatically established generally requiring proper pre-alignment of respective components in order to avoid damages to contact elements such as contact pins and the like.

In this context it shall be noted that the contact elements, such as contact pins and mating receptacles, can be part of respective mating connectors.

In a further embodiment, at least one spring element is provided which is designed for generating a pressing force directed towards the fixture or transparent section. Preferably the spring element acts upon at least one of the touch-field control unit, electronic board, actuator and reflector. Such additional spring elements can be provided if pressing forces of snap-elements and so on are likely to fail with fixing or attaching respective components reliably and sufficiently strong. In particular regions of high mass or weight load can be additionally secured and affixed by such spring elements.

In a special configuration of the user interface that uses snap elements, at least one snap element which is already exerting a pressing force to a touch-field control unit, electronic board, actuator and reflector is designed and configured such that upon deflection of the snap element in a direction opposite or transverse to the pressing force, away from the respective component for example, a slanted detent face thereof being raised thereby causing yet further overlap or further pitch with an engagement face of the respective component. Upon releasing the snap element a pressing force higher than the pressing force prevailing beforehand results. Such a snap element greatly simplifies assembly of the user interface.

Such a favourable snap element can comprise a resilient clip and detent element resiliently attached or resiliently moulded to the clip. Here, the detent element can in principle move swing independently from the clip. It is in particular possible that the clip itself can be deflected relatively to a first pivot axis, and that the detent element can be deflected relatively to a second pivot axis running parallel and spaced from the first pivot axis.

According to independent claim 12, an appliance of household or industrial type is provided, which comprises at least one user interface in any configuration described so far. As to advantages and advantageous effects of the appliance, reference is made to the discussion above.

The user interface can be used with a great variety of appliances, such as ovens, in particular baking ovens, cooking ovens and microwave ovens, cooking hobs, refrigerators, freezers, washing machines and dishwashers, for example.

Embodiments of the invention will now be described in connection with the annexed figures, in which
- Fig. 1: shows a perspective back view of a user interface of a first embodiment;
- Fig. 2: shows a mounting frame of the user interface of Fig. 1;
- Fig. 3: shows a back view of the mounting frame with a touch-field control unit being mounted thereto;
- Fig. 4: shows the touch-field control unit of Fig. 3;
- Fig. 5: shows an electronic board to be mounted to the mounting frame;
- Fig. 6: shows a cross sectional partial view of the user interface;
- Fig. 7: shows a reflector;
- Fig. 8: shows a cross sectional view of the user interface with the reflector being mounted to thereto;
- Fig. 9: shows a back view of a user interface of a second embodiment;
- Fig. 10: shows a touch-field control unit of the user interface of Fig. 9;
- Fig. 11: shows a back view of a mounting frame of the user interface of Fig. 9;
- Fig. 12: shows a front view of a positioning frame;
- Fig. 13: shows a cross sectional view a user interface in an actuator region;
- Fig. 14: shows a detail of a snap connection;
- Fig. 15: shows an enlarged view of a snap connector.

The invention will now be described in connection with a user interface of a household cooking oven. However, this shall not be construed as limiting the scope of the invention. Rather, the invention can be applied and used in connection with any other type of household appliance, for example washing machines, dishwashers, microwave ovens, refrigerators, freezers and the like.

If not otherwise stated like elements are denoted by like reference signs throughout the figures. The figures may not be true to scale, and scales of different figures may be different.

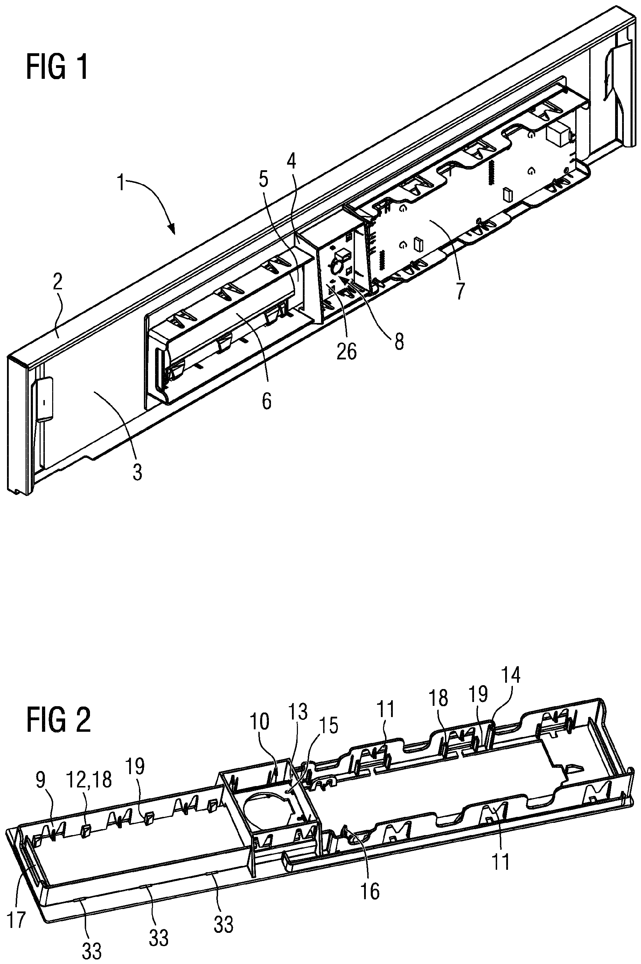

Fig. 1 shows in a perspective back view of a first embodiment of a user interface 1 of a cooking oven.

Note, that the term back view or back side shall mean that in the ordinary mounting position, the respective side is oriented towards the cooking oven or interior thereof and is therefore not visible from the outside. The term front view or front side shall mean that the respective side is oriented away from the appliance, if applicable visible from the outside.

The user interface 1 comprises a fixture 2 that can be attached to the cooking oven (not shown). A glass plate 3 is inlaid into the fixture 2, the front side of which constitutes a front face presented to a user of the cooking oven.

A mounting frame 4 of the user interface 1 is glued to the back side of the fixture 2, in more detail to the glass plate 3. A touch-field control unit 5, a reflector 6 and an electronic board 7 are detachably mounted to the mounting frame 4. The mounting frame 4 further comprises a section to which an actuator 8, which may be a push and/or rotating type button, is detachably mounted to.

Fig. 2 shows the mounting frame 4 in more detail. The mounting frame 4 comprises first to third snap connectors 9, 10 and 11, which are designed and adapted for detachably mounting the touch-field control unit 4, the electronic board 7 and actuator 8, at least a circuit board thereof.

Further, first to third guiding elements 12, 13, 14 are provided, which are designed and adapted to guide the touch-field control unit 5, the electronic board 7 and actuator 8 during the process of mounting them to the mounting frame 4.

In addition, first and second positioning pins 15 and 16 are provided with the mounting frame 4. Furthermore, the mounting frame 4 comprises a lateral stop 17, several transversal stops 18 and several depth stops 19.

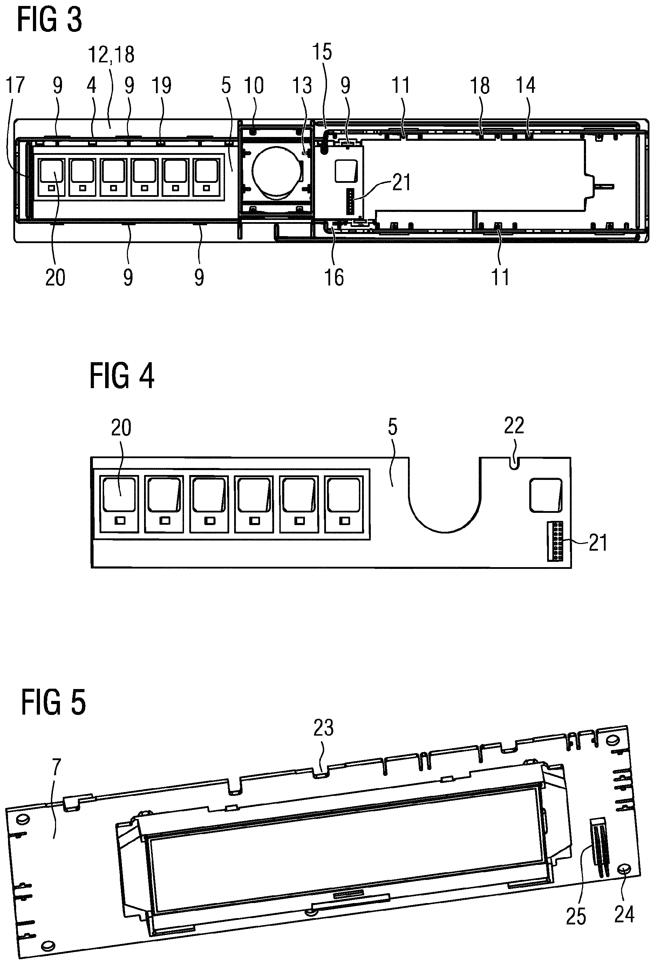

Fig. 3 shows a back view of the mounting frame 4 with the touch-field control unit 5 being mounted thereto. As can be seen, the touch-field control unit 5 comprises several touch sensors 20, and further a connector strip 21 with electric contact elements projecting from the back side of the touch-field control unit 5.

The process of mounting the touch-field control unit 5 to the mounting frame 4 is now described with particular reference to Fig. 3. Note that the terms right hand side and left hand side, upper and lower used insofar correspond to respective representation shown in the Figures.

The touch-field control unit 5, which as such is shown in Fig. 4, is first pushed into the mounting frame 4 from the right hand side (Fig.3) towards the left hand side in a slightly tilted manner. The touch-field control unit 5 is pushed into the mounting frame 4 underneath the section adapted to receive the actuator 8 whilst upper and lower edges of the touch-field control unit 5 are guided by longitudinal guides respectively running from the right hand side to the left hand side. Here, guiding slots may be used. However, it is also possible that the first snap connectors 9, the first guiding elements and respective depth stops 19 additionally function as guiding elements.

The touch-field control unit 5 is pushed towards the left hand side until its left face side abuts the lateral stop 17. At this stage, the touch-field control unit 5, in particular its right hand side, is pressed downwards such that at least the first snap connectors 9 positioned right-hand the actuator mounting section engage the touch-field control unit 5 in respective upper and lower edge sections. In doing so, a positioning notch 22 engages the first positioning pin 15.

After performing these steps, the touch-field control unit 5 is detachably mounted to the mounting frame 4 with proper and fixed alignment in lateral, i. e. horizontal, and transverse, i. e. vertical, direction. Further, the level of the touch-field control unit 5 is properly adjusted via the depth stops 19 or guiding elements, such as guide rails. In particular, horizontal and vertical movement as well as movement in depth direction can be prevented.

Fig. 5 shows in a front view the electronic board 7 to be mounted to the mounting frame 4. The electronic board 7 is mounted to the mounting frame 4 as follows: The electronic board is put onto the right hand side of the mounting frame 4 (Fig. 3), in more detail onto the third snap connectors 11. The electronic board 7 is positioned in such a way that the third guiding elements 14 engage respective guiding notches 23, and that the second positioning pin 16 engages a positioning hole 24 of the electronic board 7. Note that at least one guiding notch 23 and a respective third guiding element 14 may be adapted to properly center the electronic board 7 in horizontal direction. Further, some of the third guiding elements 14 may be adapted to properly center the electronic board in vertical direction. Now, the electronic board 7 is pushed downwards, i. e. towards the mounting frame 4, such that it slides along the third guiding elements 14 and second positioning pin 16 until the third snap connectors 11 engage the electronic board 7, in more detail respective edge sections thereof, and until the electronic board 7 abuts respective depth stops 19. As can be seen, a proper alignment of the electronic board 7 is automatically achieved upon snapping it into the mounting frame 4.

In the course of snapping the electronic board 7 into the mounting frame 4, the connector strip 21, i.e. respective contact elements, is/are automatically connected to a respective further connector strip 25, i. e. respective further contact elements of the electronic board 7. In this way, the touch-field control unit 5 and the electronic board 7 are electrically connected in an automated manner, which simplifies and speeds up the mounting procedure. Establishing the electric contact between the touch-field control unit 5 and the electronic board 7 is greatly facilitated by the fact that the touch-field control unit 5 is properly aligned once mounted to the mounting frame 4, and that the electronic board 7 can be mounted to the mounting frame in proper alignment relative to the touch-field control unit 5.

After mounting the touch-field control unit 5 and electronic board 7, the actuator 8, or at least a circuit board 26 thereof, can be snap connected to the mounting frame 4. The actuator 8, in more detail the circuit board 26, can be put from the back side into the respective opening such that the second guiding elements 12 engage respective guiding notches. At this stage, the circuit board 26 can be pressed towards the mounting frame 4 such that the second snap connectors 10 engage the circuit board 26. In this way, the circuit board 26 is detachably mounted to the mounting frame 4 in proper alignment. After snap connecting the circuit board 26 to the mounting frame 4 further components of the actuator 8, such as a knob 27 and the like, can be connected to the circuit board 26 from the front or back side.

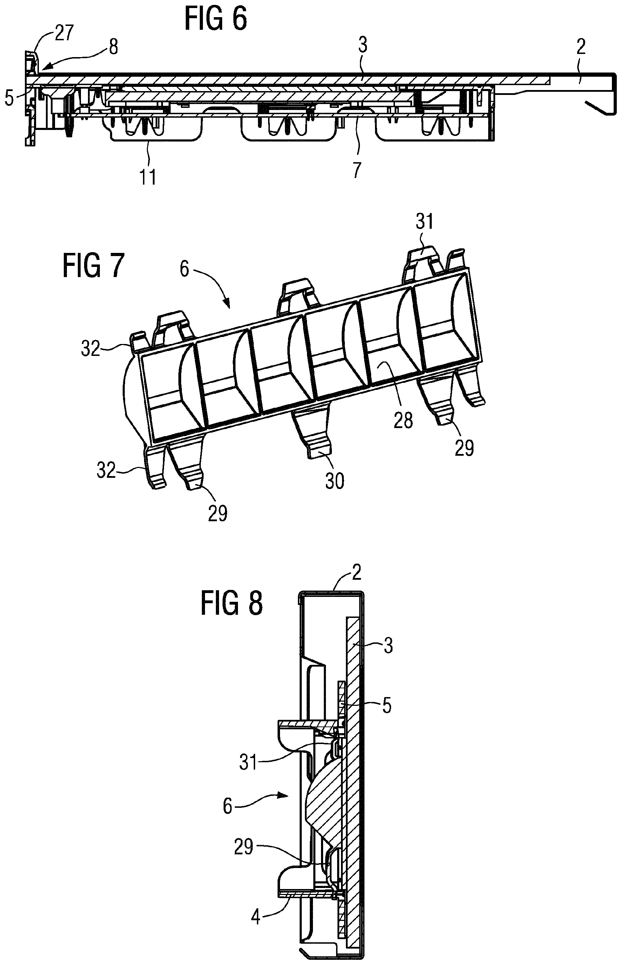

Fig. 6 shows a cross sectional partial view of the user interface 1. From Fig. 6 it becomes clear that the touch-field control unit 5 is positioned immediately at the glass plate 3 and runs underneath the mounting section for the actuator 8 or circuit board 26. Further it can be seen, that the touch-field control unit 5 and the electronic board 7 partially overlap in a region in which the connector strip 21 and further connector strip 25 are positioned. Such a partial overlap may be advantageous in view of mechanical stability, but is not mandatory. Such a configuration in particular allows to automatically establishing electronic contact between the touch-field control unit 5 and electronic board 7.

Fig. 7 shows the reflector 6 in more detail. The reflector 6 comprises several reflector zones 28 corresponding to respective touch sensors 20. The reflector 6 further comprises outer spring hooks 29 and a central spring hook 30. In addition, the reflector 6 comprises reflector snap hooks 31 and optionally upper and lower reflector stops 32. The reflector 6 is mounted to the mounting frame 4 as follows, where further reference is made to Fig. 8 showing a cross sectional view of the user interface 1.

First, the outer spring hooks 29 and the central spring hook 30 are inserted into respective slots 33 (Fig. 2). Then, the reflector snap connectors 34 are engaged with the reflector snap hooks 31, in a pushing action for example. The reflector 6, in particular the outer spring hooks 29, the central spring hook 30 and the reflector snap hooks 31 are designed such that the reflector urges the touch-field control unit 5 towards the glass plate 3. Thereby it can be assured that the touch-field control unit 5 always is urged and butts against the glass plate 3, securing proper function of the touch sensors 20.

In general, the reflector 6 shall be properly aligned with respect to lateral, transversal and depth direction. If required, the upper and lower reflector stops 32 can be designed and adapted to fine tune depth alignment of the reflector 6. Further the central spring hook 30 and the respective slot 33 may be implemented with minimal play there between, thereby greatly restricting, or even preventing, lateral movability of the reflector 6.

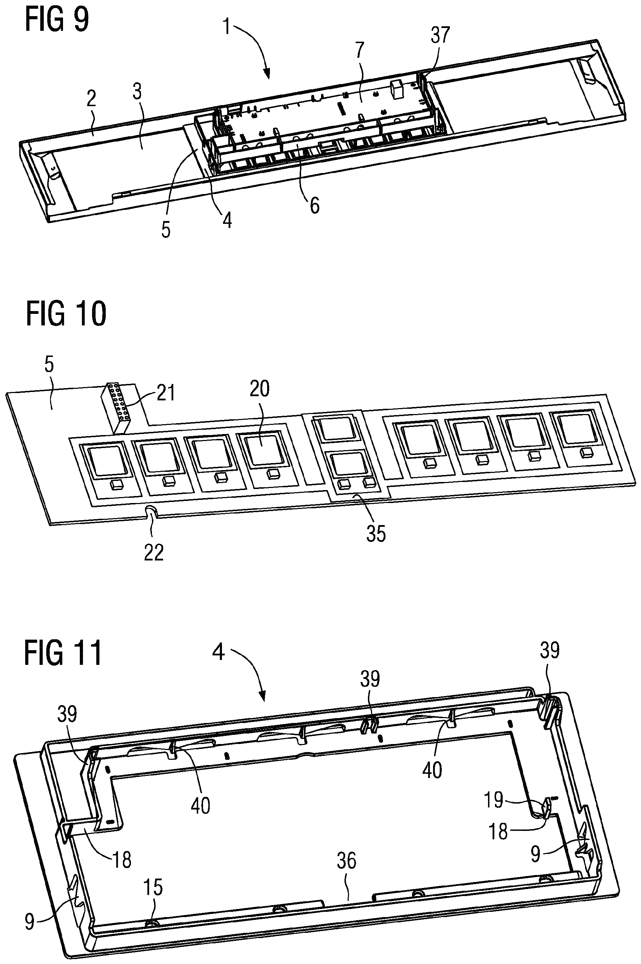

Fig. 9 shows a back view of a user interface 1 of a second embodiment. Note that the second embodiment is described only with respect to relevant constructional differences to the first embodiment. It shall be noted that all elements and components shown and described in connection with the first embodiment can be implemented with the second embodiment even if not expressly mentioned.

As becomes obvious from Fig. 9, the touch-field control unit 5, the electronic board 7 and the reflector 6, which is only optional, are successively arranged one after the other with a maximum of overlap.

Fig. 10 shows a back view of the touch-field control unit 5 of the user interface 1 of Fig. 9. The touch-field control unit 5 comprises several touch sensors 20, a connector strip 21, a positioning notch 22 and a positioning edge 35.

Fig. 11 shows a back view of a respective mounting frame 4 to which the touch-field control unit 5 is mounted to. The mounting frame 4 comprises a first positioning pin 15 and a positioning recess 36.

The touch-field control unit 5 is mounted to the mounting frame 4 as follows: First, the positioning notch 22 is engaged with the first positioning pin 15. This secures the touch-field control unit from lateral, i.e. horizontal, movement. In doing so, the lower edge of the touch-field control unit 5 abuts a respective lower rim of the mounting frame 4 and the positioning edge 35 engages the positioning recess 36.

Then the touch-field control unit 5 is pressed towards the mounting frame 5 such that the first snap connectors 9 engage respective sites of the touch-field control unit 5. Once snapped in, upper left and right edges of the touch-field control unit abut respective transversal stops, securing the touch-field control unit 5 from transversal, i.e. vertical, movement. As can be seen, the touch-field control unit 5 can easily be mounted in a detachable manner to the mounting frame 4, with the touch-field control unit 5 being fixedly and properly aligned and secured.

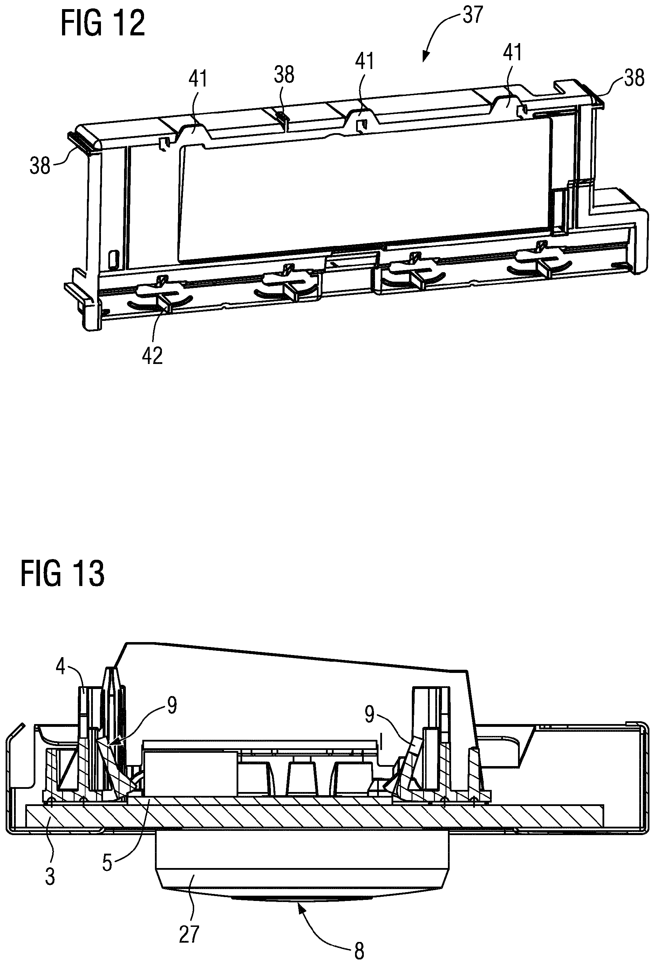

The electronic board 7 of the second embodiment is configured like the one of the first embodiment. In contrast to the first embodiment, the electronic board 7 in the present case is snap connected to a separate positioning frame 37 which is shown in more detail in Fig. 12. Snap connecting the electronic board 7 to the positioning frame 37 is conducted similarly to snap connecting the electronic board 7 of the first embodiment to the mounting frame 7. However, it is also or in addition possible that an upper or lower edge of the electronic board 7 first is inserted into retaining straps protruding from the positioning frame 37. Then the electronic board 7 can be pushed towards the positioning frame 37 thereby engaging respective snap connectors with respective snap sites of the electronic board 7. Further, any type of guides, lateral, transversal and depth stops can be provided in order to properly and fixedly align the electronic board 7 to the positioning frame 37.

Once the electronic board 7 is mounted to the positioning frame 37, the positioning frame 37 can be mounted to the mounting frame 4. This can be conducted as described below, where further reference is made to Fig. 12 showing a front view of the positioning frame 37, i. e. a side of the positioning frame 37 finally facing the touch-field control unit 5.

First, the positioning frame 37 is placed on the mounting frame 4 such that third positioning pins 38 of the positioning frame 37 engage fourth guiding elements 39 of the mounting frame 4. Note that the positioning pins 38 and fourth guiding elements 39 can be interchanged.

Then the positioning frame is pushed towards the mounting frame 4, with the positioning pins 38 sliding along the fourth guiding elements 39, until fourth snap connectors 40 of the mounting frame 4 engage respective snap noses 41 of the positioning frame 37.

Via the positioning pins 38 and fourth guiding elements 39 the positioning frame 37 is properly and fixedly aligned relative to the mounting frame 4, and is also secured against lateral, i. e. horizontal, or transversal, i.e. vertical, movement. Depth stops 19 provided with the positioning frame 37 ensure that the positioning frame 37 is positioned at a proper mounting level.

Upon mounting the positioning frame 37 to the mounting frame 4, the connector strip 21 of touch-field control unit 5 is automatically connected to a respective further connector strip provided on the electronic board. As the positioning pins 38 and guiding elements 39 prevent the positioning frame 37, and thereby the electronic board, from being tilted or moved in vertical or horizontal direction in the course of pushing them into the mounting frame 4, damages to the connector strip 21 and further connector strip or contact pins thereof can greatly be avoided.

Protrusions 42, in particular spring protrusions, protruding from a front side of the positioning frame, i.e. the side finally facing the touch-field control unit 5, are designed and adapted to exert a pressing force upon the touch-field control unit 5 in a direction towards the glass plate 3. The pressing force is such that the touch-field control unit 5 is urged against the glass plate 3 in such a manner that optimal functionality and sensitivity of the touch sensors 20 can be achieved.

If a reflector 6 is to be mounted to the touch-field control unit 5 of the second embodiment, the mounting frame 4 can comprise respective fastening elements, such as pin-hole-connector pairs, via which the reflector 6 can be attached to the mounting frame 4. In this case, the protrusions 42 mentioned beforehand, or additional protrusions, may be used to exert a pressing force upon the reflector 6 in turn urging the touch-field control unit 5 towards the glass plate 3 such that the touch-field control unit 5 properly abuts the glass plate 3. If the reflector 6 is situated between the protrusions 42 and the touch-field control unit 5, the protrusions 42 can be shortened accordingly.

If desired, the user interface according to the second embodiment may further comprise an actuator 8 as already described in connection with the first embodiment.

Fig. 13 shows a cross sectional view a user interface in an actuator region. The actuator 8 comprises a circuit board 26 arranged at a back side, and a knob 27 arranged at a front side of the user interface 1. The circuit board 26 is snap connected to the mounting frame 4 as already described further above. The knob 27 can be inserted into a respective opening or hole of the glass panel 3 after the circuit board 26, and preferably the touch-field control unit 5 and electronic board 7, is/are mounted to the mounting frame.

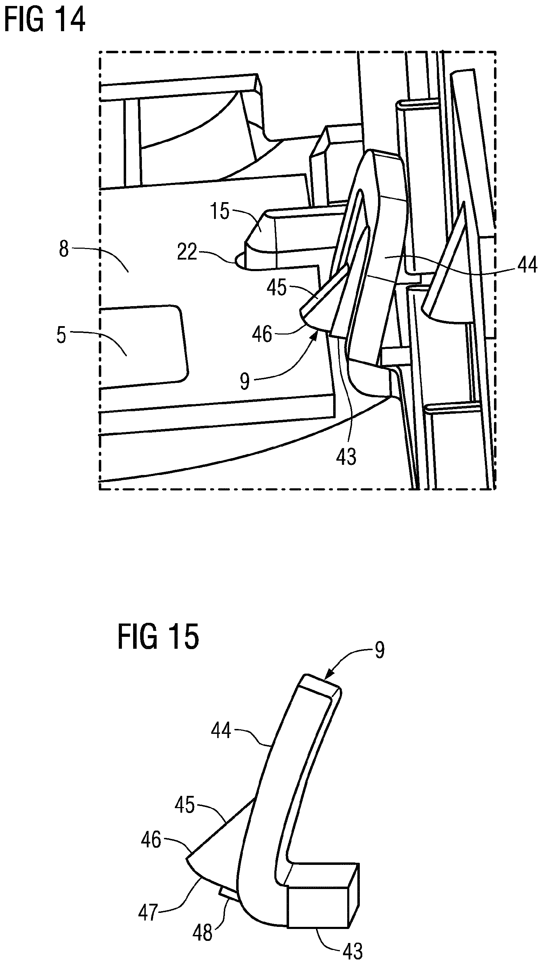

Fig. 14 shows a detail of a snap connection with respect to a snap connector 9 provided for snap connecting the touch-field control unit 5. Fig. 15 shows an enlarged view of the snap connector 9. Albeit Fig. 14 shows a snap connection of the touch-field control unit 5, the snap connection is not restricted to the touch-field control-unit, but can be applied to all other snap connections mentioned so far, i.e. to first to fourth snap connectors 9 to 11 and 40. Therefore, the function of the snap connector 9 will be described in general terms using the term "element" instead of touch-field control unit 5. However, for sake of simplicity, the reference sign 9 is representatively used for the snap connector.

The snap connector 9 comprises a base 43, from which a reversed U-shaped clip 44 extends upwardly. The clip 44 is resiliently connected or moulded to the base 43. Further, a detent element 45, in the present case comprising a detent hook 64 protruding in forward direction from the detent element 45, extends downwardly from an upper bar of the clip 44. The detent element 45 is resiliently connected or moulded to the upper bar, i.e. clip 44.

If an element, such as the touch-field control unit 5, is snap connected, it is pushed downwards past the clip 44 and the detent element 45 is first moved backwards, away from the element. If the element has passed the detent element 45, the latter again moves in, i.e. forwards, thereby engaging the edge of the element. The detent element 45 prevents the element from moving up again. As a detent surface 47 is slanted and convex, the detent element 45 exerts to the element a pressing force acting obliquely downwards in forward direction.

The special configuration of the snap connector 9 allows to retrospectively increase the pressing force exerted on the element. As the clip 44 is resiliently connected to the base 43, the upper side of the clip 44, the upper bar for example, can be pushed backwards, i. e. in a direction opposite to the forward direction. In doing so, the detent surface 47 is elevated and the detent element 45 can move further in forward direction such that the overlap between the detent surface 47 and the element increases while the slanted detent surface 47 continuously abuts the element. By pushing the detent element outwards, the bias or spring force of the detent element 45 is increased and, as the detent surface 47 abuts the element, an increased pressing force is exerted on the element upon releasing the clip 44 again.

The detent element 45 can further comprise a step-like flap 48 protruding in downward direction of the detent element 45 and acting as lateral or transversal stop.

As can be seen, the retention force of the snap connector 9 can be increased retrospectively, leading to a safe and reliable snap connection. Further, the force needed to push the element past the snap connector 9 can first be kept at a comparatively low level, while in retrospect it is still possible to achieve comparatively high pressing forces.

It shall be noted, that edges of the element can be chamfered such that the force needed to push the element past the snap connectors can be kept at a low level as compared to sharp edges.

In all it becomes clear that the user interface as proposed herein can easily be assembled and disassembled again in a time saving manner but still allows to reliably and precisely position and fix respective elements.

### List of reference numerals

- 1: user interface
- 2: fixture
- 3: glass plate
- 4: mounting frame
- 5: touch-field control unit
- 6: reflector
- 7: electronic board
- 8: actuator
- 9 - 11: first to third snap connectors
- 12 - 14: first to third guiding elements
- 15 - 16: first and second positioning pins
- 17: lateral stop
- 18: transversal stop
- 19: depth stop
- 20: touch sensor
- 21: connector strip
- 22: positioning notch
- 23: guiding notch
- 24: positioning hole
- 25: further connector strip
- 26: circuit board
- 27: knob
- 28: reflector zone
- 29: outer spring hook
- 30: central spring hook
- 31: reflector snap hook
- 32: upper and lower reflector stop
- 33: slot
- 34: reflector snap connector
- 35: positioning edge
- 36: positioning recess
- 37: positioning frame
- 38: third positioning pin
- 39: fourth guiding element
- 40: fourth snap connectors
- 41: snap nose
- 42: protrusion
- 43: base
- 44: clip
- 45: detent element
- 46: detent hook
- 47: detent surface
- 48: step-like flap

## Claims

1. User interface (1) adapted to be used with an appliance of household or industrial type, especially for a domestic appliance, comprising a fixture (2) with a transparent cover (3) positioned and fixed thereon, a touch-field control unit (5) and an electronic board (7), the touch-field control unit (5) and the electronic board (7) being detachably mounted to a mounting frame (4), and the mounting frame (4) being attached to the fixture, wherein the touch-field control unit (5) and the electronic board (7) are arranged and designed such that electric contact between electric contact elements (21, 25) of the at least one touch-field unit (5) and the electronic board (7) is automatically established upon mounting them to the mounting frame (4),
**characterised in that**
the user interface (1) comprises at least one reflector unit (6) arranged to a side of the touch-field control unit (5) averted from the fixture (2) or transparent cover (3), wherein the reflector unit (6) presses the touch-field control unit (5) against the fixture (2) or transparent cover (3) .

2. User interface (1) according to claim 1, wherein the touch-field control unit (5) is of infrared or capacitive type.

3. User interface (1) according to claim 1 or 2, wherein a transparent cover (3) made of glass, a glass analogue material or plastic, is fixed to the fixture (2), and wherein the mounting frame (4) is attached to the transparent cover (3), favourably via glue.

4. User interface (1) according to at least one of claims 1 to 3, at least one pair of touch-field control unit (5) and electronic board (7) being arranged with at least partial overlap in successive planes, and the contact elements (21, 25) being arranged in a region of overlap on respective sides facing each other.

5. User interface (1) according to at least one of claims 1 to 4, the electronic board (7) being detachably mounted to a positioning frame (37) in turn being detachably mounted to the mounting frame (4) or fixture (2).

6. User interface (1) according to claim 5, further comprising at least one actuator (8) detachably mounted to at least one of the mounting frame (4) and positioning frame (37).

7. User interface (1) according to claim 5 or 6, wherein the positioning frame (37) presses the touch-field control unit (5) against the fixture (2) or transparent cover (3) and/or presses the reflector unit (6) against the touch-field control unit.

8. User interface (1) according to at least one of claims 6 to 7, at least one of the mounting frame (4), positioning frame (37) and fixture (2) comprising at least one of snap elements (9, 10, 11, 40) and guides (12 - 16, 38, 39) designed and adapted to engage the at least one touch-field control unit (5), at least one electronic board (7), at least one actuator (8), at least one reflector (6) and positioning frame (37), respectively, and preferably adapted and designed to generate a pressing force towards the fixture (2) or transparent cover (3).

9. User interface (1) according to at least one of claims 6 to 8, wherein the at least one of the mounting frame (4), positioning frame (37) and fixture (2) comprising at least one of lateral stops (17), transversal stops (18) and height or depth stops (19), arranged and adapted for proper alignment of the at least one touch-field control unit (5), electronic board (7), actuator (8), reflector (6), the positioning frame (37) and mounting frame (4), wherein said lateral stops (17), transversal stops (18) and height or depth stops (19) are defined in relation to the mounting direction.

10. User interface (1) according to at least one of claims 6 to 9, further comprising at least one spring element for generating a pressing force directed towards the fixture (2) or transparent cover (3) and acting upon at least one of the touch-field control unit (5), electronic board (7), actuator(8) and reflector (6).

11. User interface (1) according to at least one of claims 6 to 10, wherein at least one snap element (9, 10, 11, 40) exerting a pressing force to at least one of the at least one touch-field control unit (5), electronic board (7), actuator (8) and reflector (6) is configured such that upon deflection in a direction opposite to the pressing force, a slanted detent face (47) thereof yet further overlaps a respective engagement face, and that upon releasing the snap element (9, 10, 11, 40) again an increased pressing force acts upon respective component (5, 6, 7, 8), and wherein the at least one snap element (9, 10, 11, 40) comprising a resilient clip (44) and a detent element (45, 46) resiliently attached or resiliently moulded to the clip (44).

12. Appliance of household or industrial type, especially domestic appliance, comprising at least one user interface (1) according to at least one of claims 1 to 11.

13. Appliance according to claim 12, selected from the group comprising ovens, in particular baking ovens, cooking ovens and microwave ovens, cooking hobs, refrigerators, freezers, washing machines and dishwashers.

## Patentansprüche

1. Benutzerschnittstelle (1), die dazu ausgelegt ist, mit einem Gerät vom Haushalts- oder Industrietyp verwendet zu werden, insbesondere für ein Hausgerät, die eine Halterung (2) mit einer transparenten Abdeckung (3), die darauf positioniert und befestigt ist, eine Berührungsfeldsteuereinheit (5) und eine elektronische Platine (7) umfasst, wobei die Berührungsfeldsteuereinheit (5) und die elektronische Platine (7) abnehmbar an einem Montagerahmen (4) montiert sind und wobei der Montagerahmen (4) an der Halterung angebracht ist, wobei die Berührungsfeldsteuereinheit (5) und die elektronische Platine (7) so eingerichtet und gestaltet sind, dass der elektrische Kontakt zwischen elektrischen Kontaktelementen (21, 25) von der wenigstens einen Berührungsfeldeinheit (5) und der elektronischen Platine (7) automatisch hergestellt wird, wenn sie an dem Montagerahmen (4) montiert werden,
**dadurch gekennzeichnet, dass**
die Benutzerschnittstelle (1) wenigstens eine Reflektoreinheit (6) umfasst, die an einer Seite der Berührungsfeldsteuereinheit (5), die von der Halterung (2) oder der transparenten Abdeckung (3) abgewandt ist, angeordnet ist, wobei die Reflektoreinheit (6) die Berührungsfeldsteuereinheit (5) gegen die Halterung (2) oder die transparente Abdeckung (3) drückt.

2. Benutzerschnittstelle (1) nach Anspruch 1, wobei die Berührungsfeldsteuereinheit (5) von einem Infrarot- oder kapazitiven Typ ist.

3. Benutzerschnittstelle (1) Anspruch 1 oder 2, wobei eine transparente Abdeckung (3), die aus Glas, einem zu Glas analogen Material oder Kunststoff gefertigt ist, an der Halterung (2) befestigt ist und wobei der Montagerahmen (4) an der transparenten Abdeckung (3) bevorzugt mittels Klebstoffs angebracht ist.

4. Benutzerschnittstelle (1) nach wenigstens einem der Ansprüche 1 bis 3, wobei wenigstens ein Paar der Berührungsfeldsteuereinheit (5) und der elektronischen Platine (7) mit wenigstens einer partiellen Überlappung in aufeinanderfolgenden Ebenen angeordnet ist und wobei die Kontaktelemente (21, 25) in einem Überlappungsgebiet auf jeweiligen Seiten, die einander zugewandt sind, angeordnet sind.

5. Benutzerschnittstelle (1) nach wenigstens einem der Ansprüche 1 bis 4, wobei die elektronische Platine (7) abnehmbar an einem Positionierungsrahmen (37) montiert ist, der seinerseits abnehmbar an dem Montagerahmen (4) oder der Halterung (2) montiert ist.

6. Benutzerschnittstelle (1) nach Anspruch 5, die ferner wenigstens einen Aktor (8) umfasst, der abnehmbar an dem Montagerahmen (4) und/oder dem Positionierungsrahmen (37) montiert ist.

7. Benutzerschnittstelle (1) nach Anspruch 5 oder 6, wobei der Positionierungsrahmen (37) die Berührungsfeldsteuereinheit (5) gegen die Halterung (2) oder die transparente Abdeckung (3) drückt und/oder die Reflektoreinheit (6) gegen die Berührungsfeldsteuereinheit drückt.

8. Benutzerschnittstelle (1) nach wenigstens einem der Ansprüche 6 bis 7, wobei der Montagerahmen (4) und/oder der Positionierungsrahmen (37) und/oder die Halterung (2) Schnappelemente (9, 10, 11, 40) und/oder Führungen (12-16, 38 , 39) umfasst, die dazu gestaltet und eingerichtet sind, die wenigstens eine Berührungsfeldsteuereinheit (5), die wenigstens eine elektronische Leiterplatte (7), den wenigstens einen Aktor (8), den wenigstens einen Reflektor (6) und den Positionierungsrahmen (37) jeweils in Eingriff zu bringen, und sind bevorzugt dazu eingerichtet und gestaltet, eine Druckkraft zu der Halterung (2) oder der transparenten Abdeckung (3) hin zu erzeugen.

9. Benutzerschnittstelle (1) nach wenigstens einem der Ansprüche 6 bis 8, wobei der Montagerahmen (4) und/oder der Positionierungsrahmen (37) und/oder die Halterung (2) laterale Stoppelemente (17) und/oder transversale Stoppelemente (18) und/oder Höhen- oder Tiefenstoppelemente (19) umfassen, die zur ordnungsgemäßen Ausrichtung der wenigstens einen Berührungsfeldsteuereinheit (5), der elektronischen Platine (7), des Aktors (8), des Reflektor (6), des Positionierungsrahmens (37) und des Montagerahmens (4) eingerichtet und ausgelegt sind, wobei die lateralen Stoppelemente (17), die transversalen Stoppelemente (18) und die Höhen- oder Tiefenstoppelemente (19) in Bezug auf die Montagerichtung definiert sind.

10. Benutzerschnittstelle (1) nach wenigstens einem der Ansprüche 6 bis 9, die ferner wenigstens ein Federelement zum Erzeugen einer Druckkraft umfasst, die zu der Halterung (2) oder der transparenten Abdeckung (3) hin gerichtet ist und auf die Berührungsfeldsteuereinheit (5) und/oder die elektronische Platine (7) und/oder den Aktor (8) und/oder den Reflektor (6) wirkt.

11. Benutzerschnittstelle (1) nach wenigstens einem der Ansprüche 6 bis 10, wobei wenigstens ein Schnappelement (9, 10, 11, 40), das eine Druckkraft auf die wenigstens eine Berührungsfeldeinheit (5) und/oder die elektronische Platine (7) und/oder den Aktor (8) und/oder den Reflektor (6) ausübt, so konfiguriert ist, dass bei einer Ablenkung in einer Richtung entgegengesetzt zu der Druckkraft eine schräge Arretierungsfläche (47) davon noch weiter mit einer jeweiligen Eingriffsfläche überlappt, und dass beim Freigeben des Schnappelements (9, 10, 11, 40) wieder eine erhöhte Druckkraft auf eine jeweilige Komponente (5, 6, 7, 8) wirkt, und wobei das wenigstens eine Schnappelement (9, 10, 11, 40) eine nachgiebige Klammer (44) und ein Arretierungselement (45, 46), das an der Klammer (44) nachgiebig angebracht oder nachgiebig an diese angeformt ist, umfasst.

12. Gerät vom Haushalts- oder Industrietyp, insbesondere Hausgerät, das wenigstens eine Benutzerschnittstelle (1) nach wenigstens einem der Ansprüche 1 bis 11 umfasst.

13. Gerät nach Anspruch 12, das aus der Gruppe ausgewählt ist, die aus Öfen, insbesondere Backöfen, Kochöfen und Mikrowellenöfen, Kochfeldern, Kühlschränken, Gefrierschränken, Waschmaschinen und Spülmaschinen besteht.

## Revendications

1. Interface utilisateur (1) conçue pour être utilisée avec un appareil de type ménager ou industriel, notamment pour un appareil ménager, comprenant un support (2) avec un couvercle transparent (3) positionné et fixé sur celui-ci, une unité de commande à champ tactile (5) et une carte électronique (7), l'unité de commande à champ tactile (5) et la carte électronique (7) étant montées de manière amovible sur un cadre de montage (4), et le cadre de montage (4) étant fixé au support, dans laquelle l'unité de commande à champ tactile (5) et la carte électronique (7) sont agencées et conçues de manière à ce qu'un contact électrique entre des éléments de contact électrique (21, 25) de ladite au moins une unité à champ tactile (5) et de la carte électronique (7) soit automatiquement établi lors de leur montage sur le cadre de montage (4),
**caractérisée en ce que**
l'interface d'utilisateur (1) comprend au moins une unité de réflecteur (6) agencée sur un côté de l'unité de commande à champ tactile (5) caché du support (2) ou du couvercle transparent (3), dans laquelle l'unité de réflecteur (6) appuie l'unité de commande à champ tactile (5) contre le support (2) ou le couvercle transparent (3).

2. Interface utilisateur (1) selon la revendication 1, dans laquelle l'unité de commande à champ tactile (5) est de type infrarouge ou capacitif.

3. Interface utilisateur (1) selon la revendication 1 ou 2, dans laquelle un couvercle transparent (3) en verre, en un matériau analogue au verre ou en plastique, est fixé au support (2), et dans laquelle le cadre de montage (4) est fixé au couvercle transparent (3), favorablement par l'intermédiaire de colle.

4. Interface utilisateur (1) selon au moins l'une des revendications 1 à 3, dans laquelle au moins une paire d'unité de commande à champ tactile (5) et de carte électronique (7) est agencée avec un chevauchement au moins partiel dans des plans successifs, et les éléments de contact (21, 25) sont agencés dans une région de chevauchement sur des côtés respectifs se faisant face.

5. Interface utilisateur (1) selon au moins l'une des revendications 1 à 4, dans laquelle la carte électronique (7) est montée de manière amovible sur un cadre de positionnement (37) qui à son tour est monté de manière amovible sur le cadre de montage (4) ou le support (2).

6. Interface utilisateur (1) selon la revendication 5, comprenant en outre au moins un actionneur (8) monté de manière amovible sur au moins l'un du cadre de montage (4) et du cadre de positionnement (37).

7. Interface utilisateur (1) selon la revendication 5 ou 6, dans laquelle le cadre de positionnement (37) appuie l'unité de commande à champ tactile (5) contre le support (2) ou le couvercle transparent (3) et/ou appuie l'unité de réflecteur (6) contre l'unité de commande à champ tactile.

8. Interface utilisateur (1) selon au moins l'une des revendications 6 et 7, dans laquelle au moins l'un du cadre de montage (4), du cadre de positionnement (37) et du support (2) comprend au moins un type d'éléments parmi des éléments d'encliquetage (9, 10, 11, 40) et des guides (12 - 16, 38, 39) conçus et adaptés pour mettre en prise ladite au moins une unité de commande à champ tactile (5), au moins une carte électronique (7), au moins un actionneur (8), au moins un réflecteur (6) et un cadre de positionnement (37), respectivement, et de préférence conçus et adaptés pour générer une force de pression vers le support (2) ou le couvercle transparent (3).

9. Interface utilisateur (1) selon l'une au moins des revendications 6 à 8, dans laquelle au moins l'un du cadre de montage (4), du cadre de positionnement (37) et du support (2) comprend au moins un type de butées parmi des butées latérales (17), des butées transversales (18) et des butées de hauteur ou de profondeur (19), agencées et conçues pour l'alignement correct de ladite au moins une unité de commande (5), de la carte électronique (7), de l'actionneur (8), du réflecteur (6), du cadre de positionnement (37) et du cadre de montage (4), dans laquelle lesdites butées latérales (17), butées transversales (18) et butées de hauteur ou de profondeur (19) sont définies par rapport à la direction de montage.

10. Interface utilisateur (1) selon au moins l'une des revendications 6 à 9, comprenant en outre au moins un élément élastique pour générer une force de pression dirigée vers le support (2) ou le couvercle transparent (3) et agissant sur au moins l'un de l'unité de commande à champ tactile (5), de la carte électronique (7), de l'actionneur (8) et du réflecteur (6).

11. Interface utilisateur (1) selon au moins l'une des revendications 6 à 10, dans laquelle au moins un élément d'encliquetage (9, 10, 11, 40) exerçant une force de pression sur au moins l'un de ladite au moins une unité de commande à champ tactile (5), de la carte électronique (7), de l'actionneur (8) et du réflecteur (6), est configuré de sorte que, lors d'une déviation dans une direction opposée à la force de pression, une face d'arrêt inclinée (47) de celui-ci vient chevaucher encore davantage une face de mise en prise respective, et lorsqu'on libère à nouveau l'élément d'encliquetage (9, 10, 11, 40), une force de pression accrue agit sur le composant respectif (5, 6, 7, 8), et dans laquelle ledit au moins un élément d'encliquetage (9, 10, 11, 40) comprenant un clip élastique (44) et un élément d'arrêt (45, 46) fixé de manière élastique ou moulé élastiquement sur le clip (44).

12. Appareil de type ménager ou industriel, notamment un appareil domestique, comprenant au moins une interface utilisateur (1) selon l'une au moins des revendications 1 à 11.

13. Appareil selon la revendication 12, choisi dans le groupe comprenant des fours, en particulier les fours de boulanger, les fours de cuisson, et les fours à micro-ondes, les plaques de cuisson, les réfrigérateurs, les congélateurs, les machines à laver et les lave-vaisselle.
